Europäisches Patentamt

European Patent Office

Office européen des brevets

(11) Publication number: 0 308 228
A2

# EUROPEAN PATENT APPLICATION

(21) Application number: 88308549.0

(22) Date of filing: 15.09.88

(51) Int. Cl.4: G 03 F 7/00

(30) Priority: 15.09.87 US 97223

(43) Date of publication of application:
22.03.89 Bulletin 89/12

(84) Designated Contracting States: DE FR GB

(71) Applicant: THE MEAD CORPORATION
2000 Courthouse Plaza NE.
Dayton Ohio 45401-1817 (US)

(72) Inventor: Adair, Paul C.
8307 Bunnell Hill Road
Springboro Ohio 45066 (US)

(74) Representative: Deans, Michael John Percy et al
Lloyd Wise, Tregear & CO. Norman House 105-109 Strand
London WC2R OAE (GB)

(54) Receiver sheet.

(57) A receiver sheet comprises a support having a layer of a developer material and a thermal initiator on its surface. The developer material is capable of reacting with a colour precursor to produce a visible image. The thermal initiator is capable of reacting with a photohardenable photosensitive composition carrying the colour precursor to provide image stability upon aging.

EP 0 308 228 A2

## Description

## RECEIVER SHEET

The present invention relates to a receiver sheet which is useful in providing visible images through reaction with a colour precursor. The invention also relates to transfer imaging sets including such a receiver sheet.

Our U.S. Patent 4,399,209 discloses a transfer imaging system. The system comprises an imaging sheet comprising a first support having a coating on the surface thereof. The coating typically includes a photohardenable composition which is encapsulated and a colour precursor which may or may not be within the microcapsules. Images are formed by image-wise exposure of the microcapsule coating to actinic radiation.

After image-wise exposure, the microcapsules are ruptured. The viscosity of the photohardenable composition increases substantially upon exposure to actinic radiation through mechanisms such as cross-linking and simple polymerization. Therefore, when the microcapsules are ruptured, the photohardenable composition which received a strong exposure will flow very little if at all while the unexposed or weakly exposed photohardenable composition can flow relatively freely.

After image-wise exposure and microcapsule rupture, the photosensitive composition and the colour precursor migrate to a receiver sheet which comprises a second support having a layer of developer material on the surface thereof. The colour precursor reacts image-wise with the developer material to form a color in the form of the desired image.

Our U.S. Patent 4,483,912 teaches that after the foregoing image formation, the image may bleed down into and across the imaging sheet which blurs and reduces the intensity of the image. That patent teaches that the image diffusion problem can be reduced by including a curing agent in the microcapsule coating which reacts with the photohardenable composition released from the microcapsules and cures or otherwise hardens it. The curing agent is contained in the same microcapsules as the photohardenable composition or in separate photoinert microcapsules.

Our European Patent Specification EP-A-0260129 discloses a new class of glossable developers. These developers are finely divided thermoplastic materials which are capable of reacting with the colour precursor to produce the image and upon heating they coalesce into a transparent film which imparts gloss to the image. These developers are highly desirable where photographic quality images are formed. Whereas the finely divided nature of conventional developers reduces gloss and detracts from image quality, these new thermoplastic developers form a thin film after colour-formation which imparts gloss and enhances image quality.

In accordance with a first aspect of the present invention, there is provided a receiver sheet comprising a support having a layer comprising a developer material on the surface thereof, said developer material being capable of reacting with a colour precursor to produce a visible image, characterised in that said developer material has a thermal initiator mixed therewith, said thermal initiator being capable of reacting with a photohardenable composition carrying said colour precursor to provide image stability upon aging.

The thermal initiator provided on the receiver sheet in admixture with the developer reacts with the photohardenable composition which is released from the microcapsules and transferred to the receiver sheet. This cures or otherwise hardens the photohardenable composition.

The thermal initiator can be encapsulated and mixed with the developer, mixed directly with the developer material before application to the support for the receiver sheet, or sprayed directly onto the receiver sheet. If the thermal initiator is encapsulated, with an inert oil carrier, this facilitates flow upon microcapsule rupture.

The thermal initiator is selected on the basis of shelf-life, reactivity with the photohardenable composition, activation temperature, lack of solubility in water, solubility in an inert oil carrier, low hydrolysis rate in the presence of water phases having a pH ranging from about 3.5 to 9.5, ease of encapsulation, and other characteristics consistent with known encapsulation techniques.

In a second and alternative aspect of the present invention, there is provided a transfer imaging set in which images are arranged to be formed by image-wise reaction of one or more colour precursors and a developer material, said set comprising:

(a) an imaging sheet comprising a first support; and a coating on the surface of said first support comprising a colour precursor and a photohardenable composition; said photohardenable composition being encapsulated in rupturable capsules as an internal phase; and

(b) a receiver sheet comprising a second support; characterised in that said second support has a layer of a developer material and a thermal initiator on the surface thereof, said developer material being capable of reacting with said colour precursor to produce a visible image, and said thermal initiator being capable of reacting with said photohardenable composition; and in that said set is adapted to form images by image-wise exposure of said coating to actinic radiation, and by rupturing capsules in the image areas with said coating in facial contact with said receiver sheet such that said internal phase is image-wise released from said ruptured capsules for image-wise transfer of the colour precursor to said receiver sheet whereby a patterned image-forming reaction occurs between the colour precursor and the developer material.

As explained in U.S. Patent 4,483,912, there is a need to cure the unhardened photohardenable composition on the surface of the receiver sheet. If not cured, image resolution diminishes upon storage as the composition bleeds into the receiver sheet and feathering occurs. A tendency has also been noticed for the receiver sheet to feel tacky in the image areas.

Because the thermal initiator cures or otherwise hardens the photohardenable composition after transfer to the receiver sheet, the receiver sheet of the present invention provides better image stability, reduces bleeding and is less tacky in the image areas. In addition, the receiver sheet of the present invention provides improved smudge resistance and solvent resistance, and makes the image more scuff proof.

In a particularly preferred embodiment, the developer material is a thermoplastic developer as described in EP-A-0260129. After transfer, these developers are heated to form a uniform film which imparts gloss to the image. The same heating step which is used to gloss the aforementioned developers is used to activate the thermal initiator and harden the transferred photohardenable composition.

The function of the thermal initiator is to cure the photohardenable composition after transfer. The chemically cured photohardenable composition is thus "frozen", and the color remains in place and does not diffuse. The thermal initiator can be encapsulated, mixed directly with the developer material before application to the support, or sprayed in solution directly onto the receiver sheet prior to or immediately after transfer.

For use in conventional encapsulation techniques, the thermal initiator should be insoluble in water, have a relatively low hydrolysis rate in water at a pH between 3.5 and 9.5 for up to two hours at 40 to 50°C. The encapsulated initiator should have an adequate shelf life. This usually means that the initiator is stable at temperatures up to about 35°C and that the initiator is activated upon heating to temperatures of about 100-120°C.

By exposing the microcapsules to actinic radiation and rupturing the microcapsules in the presence of a developer material, the color precursor and the developer material react to produce color in the form of an image, and the thermal initiator reacts with the photohardenable composition and hardens it to thereby improve image stability and reduce tack.

Useful thermal initiators which are reactive with ethylenically unsaturated compounds include organic peroxides and azo compounds. Suitable peroxides include diacyl peroxides such as benzoyl peroxide; ketone peroxides; peroxydicarbonates; alkyl peroxides; alkyl hydroperoxides; sulfonyl peroxides; and peroxybenzoates such as t-butylperoxybenzoate.

Suitable azo compounds include 1,1'-azobis (cyclohexanecarbonitrile) which is commercially available under the designation Vazo 88 and 2,2'-azobis (2-methylbutanitrile) which is commercially available under the designation Vazo 67 from E.I. DuPont de Nemours & Company. Other suitable azo compounds include 2,2'-azobis(2,4,4-trimethylpentane) which is commercially available as VR-110 and 2-(carbamoylazo) isobutyronitrile which is commercially available as V-30 from Wako. Other useful thermal initiators are bisazides, perborates, and diazo compounds.

Carrier oils conventionally used in forming pressure-sensitive microcapsules can be used provided that they are essentially inert to the curing agent. Examples include deodorized kerosene, alkylated biphenyls, and alkylated phthalates.

The encapsulation process chosen must give a high yield of thermal initiator. The temperature during manufacture and storage must be maintained below levels that would cause rapid decomposition of the thermal initiator. For this reason, thermal initiators which are not activated at temperatures below about 30°C are preferably used.

Whether the thermal initiator is encapsulated, mixed with the developer material, or sprayed directly on the receiver sheet, the initiator need not present in high amounts on the surface of the receiver sheets. As a general rule, amounts corresponding to 5% or less based on the amount of photohardenable composition on the imaging sheet are more than sufficient. Typically amounts as low as 0.1 to 2% of the composition are used. In some situations, peroxides can present a fire hazard. This problem can be avoided by limiting the amount of peroxide used. Typically, the amount of peroxide used is about 0.1 to 1.0% of the weight of the photohardenable photosensitive composition used.

Useful supports for the receiver sheet can be transparent or opaque. Typically, the support is paper. Transparencies are obtained using synthetic film such as polyethylene terephthalate.

The developer material used in the present invention is essentially any material capable of reacting with a color precursor to produce a colour image. Preferably, the developer material is a finely divided thermoplastic material which is capable of coalescing into a thin film which imparts gloss to the image upon the application of heat. Their softening points typically range from about 100 to 200°C, but those skilled in the art will appreciate that materials with higher and lower softening points may also be useful. The particle size is preferably in the range of about 0.5 to 25 microns.

A typical example of a thermoplastic developer material useful in practice is phenolic resins. Phenolic resins have been conventionally used as developer materials in pressure-sensitive recording materials. These resins may be the condensation product of phenols (including substituted phenols) and formaldehyde. The resins may be further modified to include amounts of salicylic acids or substituted salicylic acids in a manner known in the art. Examples of phenolic resins useful in practice are described in U.S. Patent Nos. 3,455,721; 3,466,184; 3,672,935; 4,025,490; and 4,226,962. Another class of phenolic resin useful in practice is the products of oxidative coupling of substituted or unsubstituted phenols or biphenols such as the resins described in our U.S. Patent No. 4,647,952 issued March 3, 1987 the disclosure of which is incorporated herein by reference.

The phenolic developers used are preferably metallated to improve their developing characteris-

tics. They may be metallised by reaction with a salt selected from copper, zinc, aluminium, tin, cobalt, and nickel salts. Most typically, the resins are zincated to improve development. The metal content of the resins generally is about 1 to 5% by weight but may range up to 15%.

Preferably, developer materials such as phenolformaldehyde condensation products are used. More particularly, alkylphenolic resins, and still more particularly, metallated products of alkylphenolic resins are used. The alkyl phenols are monosubstituted by an alkyl group which may contain 1 to 12 carbon atoms. Examples of alkyl phenols include ortho- or para-substituted ethylphenol, propylphenol, butylphenol, amylphenol, hexylphenol, heptylphenol, octylphenol, nonylphenol, t-butylphenol, and t-octylphenol.

Another class of thermoplastic developer material is a resin-like condensation product of a polyvalent metal salt, such as a zinc salt, and a phenol, a phenolformaldehyde condensation product or a phenol-salicylic acid-formaldehyde condensation product. This developer material is available from Schenectady Chemical Co. under the designation HRJ 4250 and HRJ 4252. These products are reported to be a metallated condensation product of an ortho- or para-substituted alkylphenol, a substituted salicylic acid, and formaldehyde.

Finely divided thermoplastic developer materials useful in practice may be obtained by several processes. A melt of any of the above developer resins can be atomized. Alternatively, a melt of the developer material can be injected into a rapidly agitated aqueous medium whereupon the melt is solidified as droplets which are recovered. The developer material can also be dissolved in a solvent/non-solvent system and the solvent removed. Other materials such as Schenectady HRJ 4250 and HRJ 4252 are obtained in a dispersed form.

In addition to the foregoing thermoplastic developers, other known developers for use in carbonless or thermographic recording paper may be used although they are generally not as desirable.

When the thermal initiator is encapsulated or mixed directly with the developer material, a binder such as latex, polyvinyl alcohol, maleic anhydridestyrene copolymer, starch, and gum arabic can be used. It is to be understood that all binders well known as film-forming materials can be used in this capacity. When spraying the thermal initiator, usually the thermal initiator is sprayed onto the receiver sheet after the developer material has been applied thereto.

To form and image-wise expose the imaging sheet the color formers, carrier oils, wall-forming materials, encapsulation techniques, coating techniques, substrates, and exposure techniques of U.S. Patent 4,399,209, the disclosure of which is incorporated herein by reference to the extent necessary to complete this disclosure, can be used. Preferred photohardenable compositions are described in EP-A-0260129.

After image-wise exposure of the imaging sheet and assembly with a receiver sheet, typically, the microcapsules are ruptured by passing the imaging sheet and receiver sheet together through a nip between two pressure rollers. Useful pressure development apparatus are disclosed in our European Patent Application 88300866.6 (Publication No. 0277806) and 88303490.2. Other useful means for rupturing the microcapsules are disclosed in our U.S. Patents Nos. 4,448,516; 4,533,615; 5,578,340; and 4,592,986.

In the preferred embodiment wherein the developer material is capable of coalescing into a thin film which imparts gloss to the image upon the application of heat, the developer material can be coalesced and the thermal initiator activated simultaneously. The receiver sheet can be heated by contact with a heated roller or a pair of heated rollers, or by passage of the receiver sheet over a heated platen. Alternatively, the receiver sheet can be placed in a hot oven.

The present invention is more fully illustrated by the following non-limiting Examples.

Example

Mixtures of 20g HRJ-4542 developer (Schenectady Chemical Co.) (at 35% solids) and 0.5 g of each of the thermal initiators identified below were coated with a number 14 wire-wound rod onto a 3 mil PET film. Microcapsule sheets containing melamine-formaldehyde capsules coated at 10g/m$^2$ on 1 mil PET film with the following internal phase were pressed against each of the developer sheets under pressure:

TMPTA    50g
2,4,6,N,N-pentamethylaniline    2g
7-diethylamino-3-cinnamoylcoumarin    0.2g
Reakt Yellow (BASF)    5g

Each of the resultant developer sheets was heated at 150°C for 30 seconds to produce a glossy sheet and a to cause the thermal initiator to react. The sheets were then cut into 3 1 in.(2.54 cm) square pieces and extracted with 4g of HPLC grade acetone. Six g of acetonitrile was added and the solution was filtered and injected into a gas chromatograph. A peak for residual, unpolymerized monomer (TMPTA) was identified and the relative peak areas for a number of thermal initiators were determined as below:

Control    45.4
benzoyl peroxide    24.7
t-butyl peroxybenzoate    35.6
Vazo 67    36.4
Vazo 88    27.6

The control receiver sheet contained more extractable monomer than the sheets containing a thermal initiator, indicating that thermal polymerization did indeed occur.

Claims

1. A receiver sheet comprising a support having a layer comprising a developer material on the surface thereof, said developer material being capable of reacting with a colour precursor to produce a visible image, characterised in that said developer material has a thermal initiator mixed therewith, said thermal initiator being capable of reacting with a photohardenable composition carrying said colour precursor to provide image stability upon aging.

2. A receiver sheet according to Claim 1, further characterised in that said thermal initiator is encapsulated in rupturable microcapsules having discrete capsule walls.

3. A receiver sheet according to Claim 1 or Claim 2, further characterised in that said thermal initiator is an organic peroxide.

4. A receive sheet according to Claim 3, further characterised in that said organic peroxide is selected from diacyl peroxides; ketone peroxides; peroxydicarbonates; alkyl peroxides; alkyl hydroperoxides; sulphonyl peroxides; and peroxybenzoates.

5. A receiver sheet according to Claim 1 or Claim 2, further characterised in that said thermal initiator is an azo compound.

6. A receiver sheet according to Claim 5, further characterised in that said azo compound is an azo **compound selected from 1,1′-azobis** (cyclohexanecarbonitrile); 2,2′-azobis (2-methylbutanitrile); 2,2′-azobis (2,4,4-trimethylpentane); and 2-(carbamoylazo) isobutyronitrile.

7. A receiver sheet according to any preceding claim, further characterised in that said developer material is a finely divided thermoplastic material capable of coalescing into a thin film which imparts gloss to said image upon the application of heat.

8. A receiver sheet according to Claim 7, further characterised in that said developer material is a phenolic resin, preferably a phenolformaldehyde resin or a metallated alkylphenolformaldehyde resin.

9. A transfer imaging set in which images are arranged to be formed by image-wise reaction of one or more colour precursors and a developer material, said set comprising:
(a) an imaging sheet comprising a first support; and a coating on the surface of said first support comprising a colour precursor and a photohardenable composition; said photohardenable composition being encapsulated in rupturable capsules as an internal phase; and
(b) a receiver sheet comprising a second support;
characterised in that said second support has a layer of a developer material and a thermal initiator on the surface thereof, said developer material being capable of reacting with said colour precursor to produce a visible image, and said thermal initiator being capable of reacting with said photohardenable composition; and in that said set is adapted to form images by image-wise exposure of said coating to actinic radiation, and by rupturing capsules in the image areas with said coating in facial contact with said receiver sheet such that said internal phase is image-wise released from said ruptured capsules for image-wise transfer of the colour precursor to said receiver sheet whereby a patterned image-forming reaction occurs between the colour precursor and the developer material.

10. A transfer imaging set in which images are arranged to be formed by image-wise reaction of one or more colour precursors and developer material, said set comprising: an imaging sheet comprising a support and a coating on the surface thereof comprising a colour precursor and a photohardenable compostion, the photohardenable composition being encapsulated in rupturable capsules as an internal phase; and a receiver sheet; characterised in that said receiver sheet is a receiver sheet according to any of Claims 1 to 8.